**Europäisches Patentamt**

**European Patent Office**

**Office européen des brevets**

(19)

(11) Numéro de publication: **0 305 301 B1**

(12)

# FASCICULE DE BREVET EUROPEEN

(45) Date de publication de fascicule du brevet: **16.09.92**

(51) Int. Cl.⁵: **H03G 7/00**, H04B 1/64

(21) Numéro de dépôt: **88420257.3**

(22) Date de dépôt: **20.07.88**

(54) **Circuit compresseur de signal, en particulier pour appareil téléphonique.**

(30) Priorité: **21.07.87 FR 8710604**

(43) Date de publication de la demande:
**01.03.89 Bulletin 89/09**

(45) Mention de la délivrance du brevet:
**16.09.92 Bulletin 92/38**

(84) Etats contractants désignés:
**DE FR GB IT NL SE**

(56) Documents cités:
**EP-A- 0 187 696**
**GB-A- 2 025 719**
**US-A- 3 602 648**
**US-A- 3 919 654**

**ELEKTOR, vol. 8, no. 2, février 1982, pages 41-45, Beek, NL; "CX and DNR", the latest in noise reduction"**

(73) Titulaire: **SGS-THOMSON MICROELECTRO-NICS S.A.**
**7, Avenue Galliéni**
**F-94250 Gentilly(FR)**

(72) Inventeur: **Defretin, Bruno**
**11, Boulevard de Jomardière**
**38120 Saint Egrève(FR)**
Inventeur: **Arnaud, Thierry**
**38, Chemin de la Taillat**
**F-38240 Meylan(FR)**

(74) Mandataire: **de Beaumont, Michel et al**
**1bis, rue Champollion**
**F-38000 Grenoble(FR)**

EP 0 305 301 B1

## Description

La présente invention concerne d'une manière générale un circuit compresseur de signal, en particulier pour appareil téléphonique, du type comprenant un préamplificateur dont une entrée reçoit un signal à traiter, et un dispositif de contrôle de gain du préamplificateur pour asservir, à une valeur prédéterminée, l'amplitude du signal de sortie du préamplificateur.

Un circuit compresseur de signal peut avantageusement être intégré dans les voies émission et réception d'un appareil téléphonique, notamment du type "mains libres" c'est-à-dire que l'appareil n'est pas équipé d'un combiné. La fonction d'un tel circuit dans ce type d'appareil est de compenser des pertes de signal dues soit à la distance séparant le locuteur du microphone lorsque l'appareil est en mode émission, soit à la longueur de ligne lorsque l'appareil est en mode réception.

Des circuits compresseurs de signaux ont été utilisés notamment pour réduire le bruit au cours d'un enregistrement magnétique. Néanmoins, ces circuits présentent une structure complexe incluant notamment des horloges et des circuits convertisseurs. De plus, ces circuits sont de grandes dimensions, et par conséquent volumineux, font appel à des tensions d'alimentation relativement élevées, compte-tenu de l'utilisation de circuits en technologie CMOS, consomment de l'énergie et sont d'un prix de revient relativement élevé.

Il résulte de ces différents inconvénients, que les circuits compresseurs, du type précité, sont inadaptés à une intégration dans les voies émission et réception des appareils téléphoniques dits "mains libres".

Un objet de l'invention est de concevoir un circuit compresseur de signal adapté pour la téléphonie.

Un autre objet de la présente invention est de prévoir un tel circuit qui soit apte à résoudre un problème spécifique qui se rencontre lorsque, en mode émission, le dispositif de contrôle de gain du préamplificateur réagit au bruit entre deux pics de parole. En effet, lorsqu'un locuteur prend la parole, il est important que le préamplificateur réagisse rapidement, mais, par contre, il ne doit pas réagir à la même vitesse entre deux pics de parole, comme par exemple entre deux syllabes, pour éviter une augmentation intempestive du gain et par conséquent du bruit de fond.

A cet effet, l'invention propose un circuit compresseur de signal, en particulier pour un appareil téléphonique du type "mains libres", comprenant un préamplificateur dont une entrée est reliée à un signal d'entrée à traiter, et un dispositif de contrôle de gain du préamplificateur pour asservir, à une valeur prédéterminée, l'amplitude du signal de sortie du préamplificateur. Le dispositif de contrôle de gain est associé à un circuit définissant deux constantes de temps, qui commandent respectivement les vitesses d'augmentation et de diminution du gain du préamplificateur en fonction de l'amplitude du signal d'entrée. Selon l'invention, le dispositif de contrôle de gain du préamplificateur comprend un redresseur double alternance permettant d'extraire la valeur crête du signal de sortie du préamplificateur et un circuit comparateur pour comparer cette valeur de crête à une valeur de référence, la sortie du circuit comparateur étant reliée à un condensateur externe qui fixe la constante de temps de la modification du gain du préamplificateur lors d'une augmentation ou d'une diminution du gain.

Selon une autre disposition de l'invention, le préamplificateur présente une impédance d'entrée élevée et est conçu pour que le dispositif de contrôle de gain agisse sur son courant de polarisation.

Selon une autre disposition de l'invention, pour fixer les constantes de temps susmentionnées, ainsi que le sens de variation du gain du préamplificateur, le circuit comparateur connecte alternativement deux sources de courant sur le condensateur suivant le résultat de la comparaison, ces deux sources de courant définissant respectivement deux constantes de temps, la constante de temps la plus courte définissant la vitesse de diminution du gain en réponse à un pic de parole, et la constante de temps la plus longue définissant la vitesse d'augmentation du gain du préamplificateur.

Le rapport entre les deux constantes de temps est fixé de façon à ne pas avoir d'augmentation intempestive du gain du préamplificateur, et donc du bruit de fond, encre deux pics de parole.

Selon un aspect de l'invention, un tel circuit compresseur de signal est avantageusement intégré dans chacune des voies émission et réception d'un appareil téléphonique du type "mains libres".

D'autres avantages, caractéristiques et détails de la présente invention ressortiront de la description explicative qui va suivre faite en référence aux dessins annexés, donnés à titre d'exemple, et dans lesquels :

la figure 1 est un schéma sous forme de blocs montrant les différents éléments constitutifs d'un compresseur de signal conforme à l'invention, pour en illustrer le principe de fonctionnement ;

la figure 2 est un schéma sous forme de blocs montrant les différents éléments constitutifs du préamplificateur du compresseur de signal illustré à la figure 1 ;

la figure 3 est un schéma de circuit détaillé d'un exemple de réalisation du préamplificateur illustré à la figure 2 ; et

la figure 4 est un schéma de circuit détaillé d'un exemple de réalisation d'une partie du circuit de contrôle de gain illustré à la figure 1.

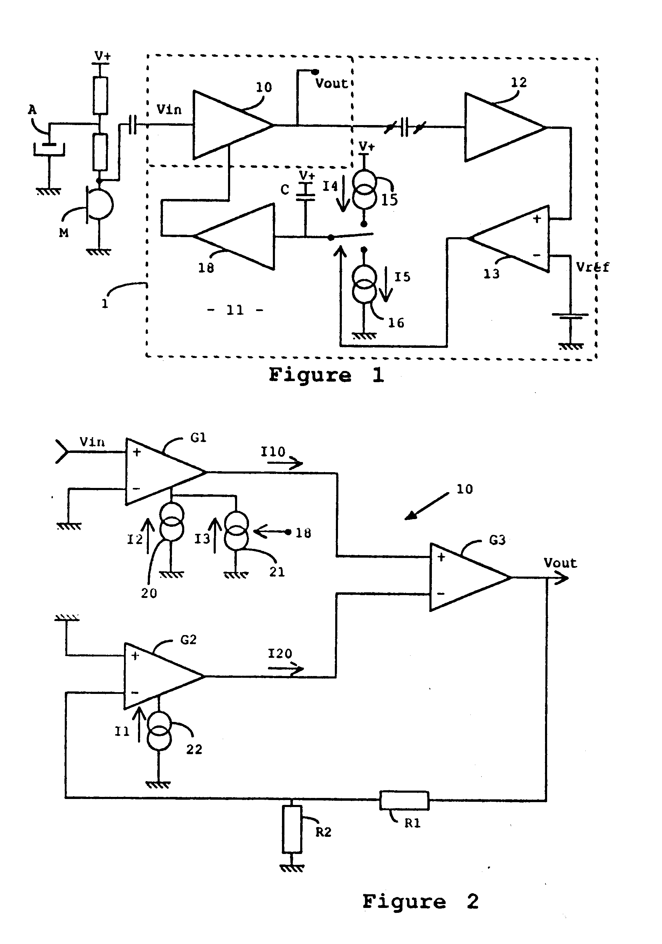

La figure 1 représente les principaux éléments constitutifs d'un compresseur de signal 1 conforme à l'invention qui, dans l'exemple considéré ici, est monté dans la voie émission d'un appareil téléphonique dit "mains libres". La représentation de cet appareil a été volontairement limitée à un microphone M, du type à électrets, et au circuit d'alimentation A du microphone M.

Le compresseur de signal 1 comprend un préamplificateur 10 et un dispositif de contrôle de gain 11 de ce préamplificateur. La borne de sortie du microphone M est reliée à la borne d'entrée du préamplificateur 10, ce dernier ayant une forte impédance d'entrée compatible avec un microphone du type à électrets.

La borne de sortie du préamplificateur 10 est connectée à l'entrée d'un circuit redresseur 12 à double alternance. La borne de sortie de ce circuit redresseur 12 est connectée à une entrée (ici l'entrée +) d'un circuit comparateur 13, dont l'autre entrée (entrée -) est reliée à une tension de référence Vref prédéterminée.

La borne de sortie du circuit comparateur 13 est reliée à l'entrée de commande d'un commutateur 17 qui permet de connecter une borne d'un condensateur extérieur C, soit à une première source de courant 15 délivrant un courant de charge I4, soit à une deuxième source de courant 16 délivrant un courant de décharge I5. La borne du condensateur C reliée au commutateur 17 est connectée à l'entrée d'un circuit convertisseur tension-courant 18, alors que l'autre borne du condensateur C est reliée à la tension d'alimentation V+. La borne de sortie du circuit convertisseur 18 est reliée à une entrée de commande du courant d'alimentation ou de polarisation du préamplificateur 10.

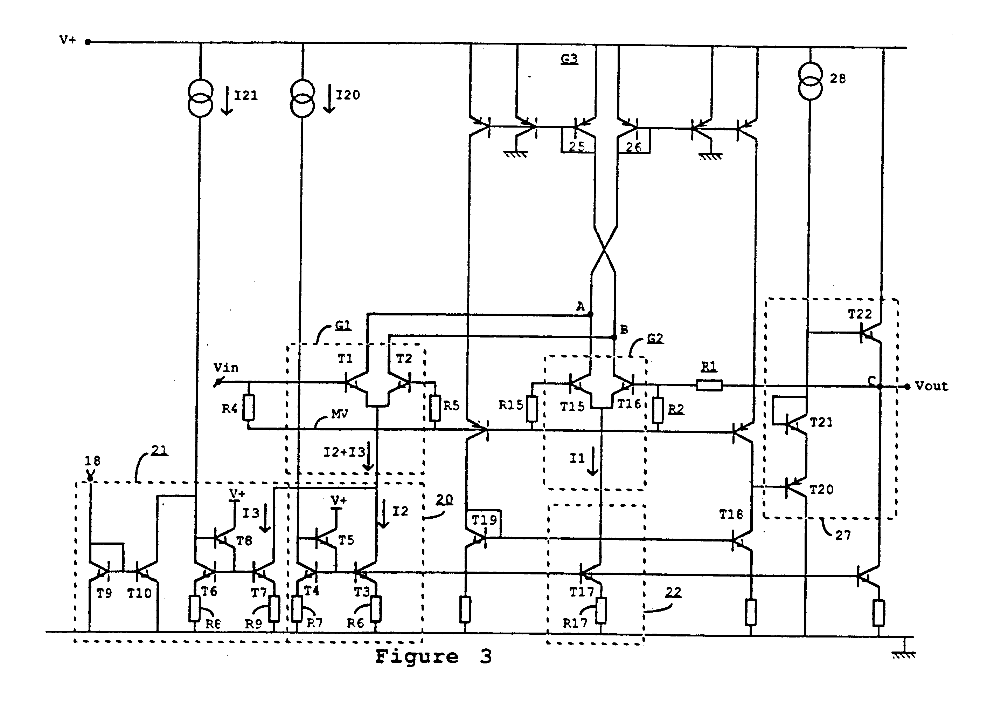

Les figures 2 et 3 représentent de façon de plus en plus détaillée la constitution du préamplificateur 10.

Comme le montre la figure 2, le préamplificateur 10 est constitué de trois amplificateurs différentiels G1, G2 et G3.

L'amplificateur différentiel G1 ou amplificateur d'entrée a une borne d'entrée (entrée +) connectée à la sortie du microphone M. L'autre entrée (entrée -) de l'amplificateur G1 est connectée à une masse virtuelle. L'alimentation de l'amplificateur G1 est assurée par deux sources de courant 20, 21 montées en parallèle. La source de courant 20 délivre un courant constant I2, alors que la source de courant 21 délivre un courant variable I3, déterminé par la sortie du convertisseur 18 et assurant le réglage du gain d'ensemble du préamplificateur 10. La borne de sortie de l'amplificateur G1 est reliée à une borne d'entrée (entrée +) de l'amplificateur G3 ou amplificateur de sortie. La borne de sortie de l'amplificateur G3, sur laquelle est prélevé le signal de sortie Vout du préamplificateur 10, est connectée à une entrée (entrée -) de l'amplificateur G2, avec interposition d'un pont diviseur de tension constitué par deux résistances R1 et R2. L'autre borne d'entrée (entrée +) de l'amplificateur G2 est reliée à une masse virtuelle, et sa borne de sortie est reliée à l'autre entrée (entrée -) de l'amplificateur de sortie G3. La borne de polarisation de l'amplificateur G2 est connectée à une source de courant 22 délivrant un courant constant I1. De même l'amplificateur G3 reçoit une polarisation fixe (non représentée).

Le circuit de la figure 2 fonctionne de la façon suivante :

Soit un signal Vin issu du microphone M et reçu à l'entrée + de l'amplificateur différentiel G1 du préamplificateur 10. La fonction de l'association de l'amplificateur G3 et des deux amplificateurs G1, G2 est de ramener sur les deux entrées de l'amplificateur G3, des signaux en courant I10 et I20 de valeur égale. La valeur du courant I10 à la sortie de l'amplificateur G1 est égale, à un facteur k près, à la tension du signal d'entrée Vin multipliée par le courant de polarisation fixé par les sources de courant 20 et 21, qui délivrent respectivement les courants I2 et I3.

Le courant I10 en sortie de l'amplificateur G1 est donc :

$$I10 = Vin \times k \times (I2 + I3).$$

Le courant I20 à la sortie de l'amplificateur G2 est proportionnel à la valeur de la tension du signal de sortie Vout prélevé à la sortie de l'amplificateur G3, multipliée par le courant de polarisation I1 fourni par la source de courant 22 et multipliée par un facteur déterminé par le pont diviseur de tension R1, R2. Le facteur de proportionalité k est le même que ci-dessus si les amplificateurs G1 et G2 sont identiques.

La valeur du courant en sortie de l'amplificateur G2 est donc :

$$I20 = Vout \times k \times I1 \times R2/(R1 + R2).$$

Les courants I10 et I20 tendant à être égaux, le gain G du préamplificateur est :

$$G = Vout/Vin = [(I2 + I3)/I1] \times [(R1 + R2)/R2].$$

Les courants I1 et I2 étant des courants constants, seule la variation du courant I3 fourni par la source de courant asservie 21 permet de modifier le gain du préamplificateur 10, de façon que la tension du signal en sortie Vout soit asservie à une valeur prédéterminée fixée par exemple à 100 mV crête. De cette manière, il est possible de compenser des pertes de signal dues à la distance séparant le locuteur du microphone M, lorsque l'appareil est en mode émission.

La figure 3 représente plus en détail la constitution des trois amplificateurs G1, G2 et G3, ainsi que les différentes liaisons électriques qui existent entre eux.

L'amplificateur G1 comprend un étage différentiel constitué par deux transistors T1, T2. La base du transistor T1 est connectée à la borne de sortie du microphone M, et est reliée à une masse virtuelle Mv par une résistance R4 d'une valeur relativement élevée, par exemple 10 kohms (on entend par masse virtuelle Mv une tension intermédiaire entre le tension d'alimentation $V^+$ et la masse, par exemple $V^+/2$). Les émetteurs des transistors T1, T2 sont connectées aux sources de courant 20 et 21 extrayant le courant I2 + I3. En sortie, les collecteurs des transistors T1, T2 de l'amplificateur G1 sont respectivement connectés à des bornes A et B correspondant aux sorties de l'amplificateur G2 et aux entrées de l'amplificateur G3.

La source de courant 20 est une source de courant constant classique comprenant un miroir de courant constitué de transistors T3, T4 et T5, le transistor T3 étant destiné à répéter le courant passant dans le transistor T4. Le transistor T4, en série avec une résistance R7, reçoit le courant d'une source de courant I20. Il passe donc dans le transistor T3 et une résistance R6 en série un courant I2 constant prédéterminé destiné à assurer une polarisation de seuil de l'amplificateur G1.

La source de courant variable 21 comprend également un miroir de courant constitué de transistors T6, T7, T8 et de résistances R8, R9. Ainsi, le courant passant dans la résistance R8 à partir d'une source de courant I21 est répété dans la résistance R9 pour fournir un courant I3. Ce courant I3 est réglable du fait qu'une partie du courant de la source de courant I21 peut être dérivée dans un transistor T10 monté en miroir de courant avec un transistor T9. Le courant dans le transistor T9 est le courant fourni en sortie par le convertisseur tension-courant 18 représenté en figure 1 et qui constitue l'élément final de la chaîne de régulation associée au préamplificateur 10.

L'amplificateur G2 comprend un étage différentiel constitué par des transistors T15, T16, et est associé à la source de courant constant 22 représentée à la figure 2. La base du transistor T15 est reliée à la masse virtuelle par une résistance R15. La base du transistor T16 est reliée à la sortie Vout de l'amplificateur G3 par le pont diviseur de la figure 2 constitué par les résistances R1, R2. Les émetteurs des deux transistors T15, T16, sont reliés à la source de courant 22 comprenant le transistor T17 et la résistance R17. La base du transistor T17 est reliée aux bases des transistors T3 et T4. La source de courant constant 22 fournit donc un courant I1 égal ou proportionnel au courant I2 fourni par la source de courant constant 20. Comme on l'a noté précédemment, l'amplificateur G2 est de préférence identique à l'amplificateur G1.

En sortie, les collecteurs des transistors T15, T16 sont respectivement reliés aux points A, B correspondant aux bornes d'entrée + et - de l'amplificateur G3.

L'amplificateur G3 n'a pas été entouré d'un bloc en pointillés car il comprend de nombreux éléments situés sur la figure à droite des blocs G1 et 20 en excluant les blocs G2 et 22.

L'amplificateur G3 comprend deux étages d'entrée en courant 25, 26, constitués respectivement par deux circuits miroirs de courant, et un étage de sortie 27. Les deux sorties des circuits 25, 26 sont respectivement reliées à deux transistors T18, T19 reliés par leurs bases, le transistor T19 étant monté en diode et ces deux transistors constituant une charge active.

L'étage de sortie 27 de l'amplificateur G3 est constitué par trois transistors T20, T21 et T22. La base du transistor T20 est reliée au collecteur du transistor T18, son collecteur est relié à la masse, et son émetteur est relié à une source de courant 28 par l'intermédiaire du transistor T21 monté en diode. La base du transistor T22 est reliée au collecteur du transistor T21, son collecteur est relié à la tension d'alimentation V + , le signal de sortie Vout étant prélevé sur son émetteur au niveau d'une borne C qui est également connectée à l'entrée de l'amplificateur G2 par l'intermédiaire du pont diviseur R1, R2 susmentionné.

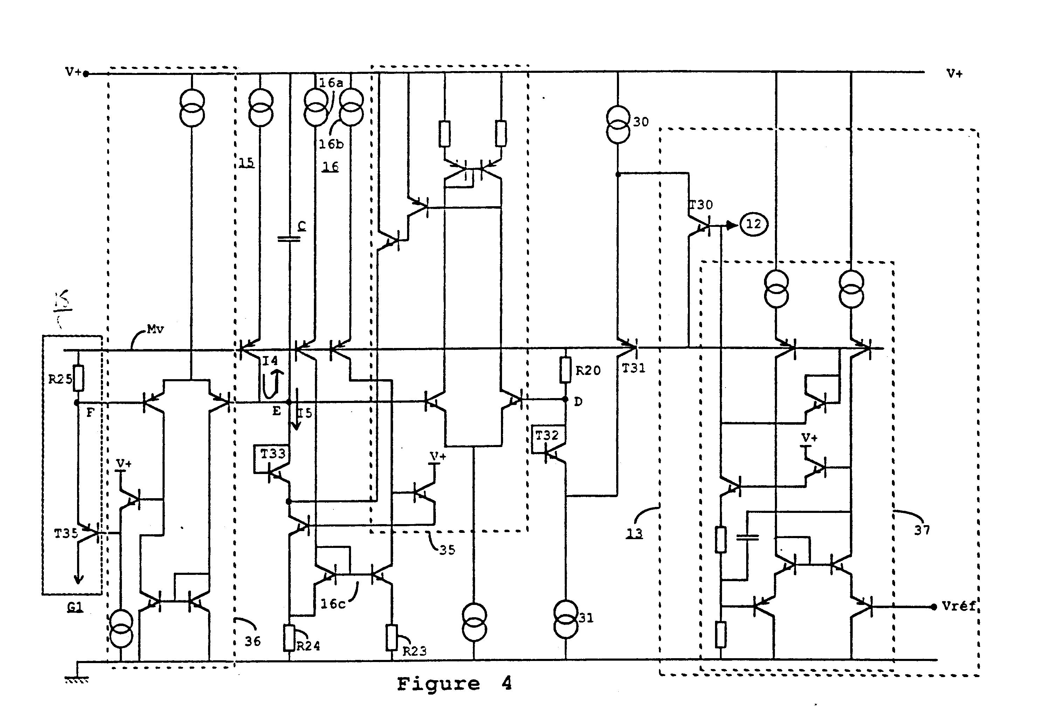

La figure 4 représente un exemple de réalisation détaillée des éléments compris entre les entrées du comparateur 13 et la sortie du circuit convertisseur tension-courant 18.

On retrouve dans la figure 4 les références 13 désignant le comparateur, 15 et 16 désignant les sources de courant, C désignant un condensateur et 18 désignant le convertisseur tension-courant de la figure 1. La référence 17 désignant le commutateur de la figure 1 n'apparaît pas en figure 4 car, comme on le verra, sa fonction est répartie entre plusieurs éléments.

Le circuit comparateur 13 est essentiellement constitué par un transistor T30 dont la base est connectée à la sortie du circuit redresseur 12 de la figure 1 et à la sortie d'un circuit 37 convertissant la tension de référence Vref en un courant. Les états bloqué ou passant du transistor T30 déterminent la fonction de commutation de l'interrupteur 17 représenté à la figure 1. L'émetteur du transistor T30 est relié à la masse virtuelle Mv et son collecteur est relié, d'une part, à une source de courant constant 30 reliée à la tension V⁺ et, d'autre part, à une autre source de courant constant 31 reliée à la masse au travers d'un transistor T31. L'émetteur d'un transistor T32 monté en diode est relié à la source de courant 31, et son collecteur est relié à la borne d'une résistance R20 dont l'autre borne est reliée à la masse virtuelle.

Le fonctionnement de ce circuit 13 est le suivant :

Le courant appliqué sur la base du transistor T30 de la figure 4 est égal à la différence des courants résultant des conversions en courant des signaux de sortie du préamplificateur 10 et de la tension de référence Vref, respectivement. En pratique, le circuit redresseur 12, de constitution classique, est, dans l'exemple considéré ici, un circuit qui délivre en sortie un signal en courant proportionnel à la valeur crête du signal de sortie en tension Vout. C'est pourquoi la tension de référence Vref doit être également convertie en un signal de courant par le circuit 37 de la figure 4.

Si la différence des courants sur la base du transistor T30 est nulle ou négative, le transistor T30 se bloque. Dans ce cas, la source de courant 31, de 10 microampères par exemple, absorbe le courant de la source 30, qui est une source de courant saturable. Dans ces conditions, aucun courant ne circule dans la résistance R20 et la tension à la borne D de la résistance R20 est celle de la masse virtuelle.

Si la différence des courants sur la base du transistor T30 devient positive, la source de courant 30 est au moins partiellement dérivée vers la masse virtuelle en traversant le transistor T30 qui devient conducteur. Ainsi, la source de courant 31 extrait d'une part une partie du courant provenant de la source 30 si celui-ci n'est pas entièrement dérivé, d'autre part entraîne le passage de courant dans la résistance R20 et le potentiel sur la borne D de la résistance R20 chute.

Un amplificateur suiveur 35 non représenté en figure 1 sert à transmettre le potentiel entre cette borne D et une borne E connectée au condensateur C dont l'autre borne est reliée à la tension d'alimentation V⁺. La fonction de cet amplificateur suiveur 35 est de transférer la tension présente aux bornes de la résistance R20, aux bornes du condensateur C (avec un certain retard comme on le verra ci-après). L'entrée D de l'amplificateur 35 est connectée au point de raccordement entre la résistance R20 et le collecteur du transistor T32, et sa sortie est reliée à la borne E du condensateur C par un transistor T33 monté en diode.

Comme cela a déjà été précisé en référence à la figure 1, le condensateur est associé à deux sources de courant 15, 16. La source de courant 15 destinée à décharger lentement le condensateur 6 selon un courant I4 est montée entre la tension d'alimentation V⁺ et la borne E du condensateur C reliée à la sortie de l'amplificateur suiveur 35. Le courant I4 est, par exemple, égal à 1 microampère. La source de courant 16 destinée à charger rapidement le condensateur C selon un courant I5 est, dans l'exemple condidéré ici, constituée par deux sources de courant 16a, 16b délivrant des courants égaux, d'une valeur de 1 microampère par exemple, qui sont amplifiés d'un facteur k1, de 100, par un circuit auxiliaire 16c. Ce circuit 16c comprend notamment deux résistances R23, R24 qui sont dans un rapport 100 pour obtenir un courant I5 de 100 microampères. Le rapport entre les vitesses de charge et de décharge est ainsi, dans cet exemple, égal à 100.

Un autre amplificateur suiveur 36 est connecté entre la borne E du condensateur C et la borne F d'un étage de sortie 18 qui constitue le convertisseur tension-courant de la figure 1, cet étage de sortie comprenant une résistance R25 et un transistor de sortie T35 reliés au niveau de la borne F. La fonction de l'amplificateur suiveur 36 est de transférer la tension présente à la borne E du condensateur C, sur la borne F de la résistance R25. La tension aux bornes de la résistance R25 va donner naissance à un courant de sortie variable, qui va permettre de faire varier le gain du préamplificateur 10.

On va maintenant décrire comment les variations de tension sur la borne D de la résistance R20 se répercutent vers les bornes E et F puis vers la source de courant variable I3.

Quand aucun courant ne circule dans la résistance R20, la borne D est au potentiel de la masse virtuelle. Alors, le condensateur C se décharge lentement sous l'effet de la source de courant 15 selon le courant I4 fixé à une valeur de 1 microampère par exemple. Le décharge du condensateur C entraine une diminution de la tension à la borne F de la résistance R25, et donc une diminution du courant dans l'émetteur du transistor de sortie T35. Cette diminution de courant est répercutée par la source de courant variable 21 pour entrainer une augmentation du courant I3 (figures 2, 3) et donc une augmentation du gain de l'amplificateur G1 et une augmentation de la valeur du signal de sortie Vout, de manière à tendre à ramener la valeur crête de ce signal de sortie à la tension de référence Vref fixée par exemple à 100 mV.

Le condensateur C se déchargeant lentement à travers la source 15, il en résulte une augmentation lente du gain de l'amplificateur G1. De cette manière, le compresseur de signal 1 conforme à l'invention permet de ne pas augmenter d'une façon intempestive le bruit de fond qui entoure le locuteur, notamment entre deux syllabes d'un mot.

Quand un courant circule dans la résistance R20 et que la tension au point D diminue, cette variation est transmise par l'amplificateur suiveur 35 aux bornes du condensateur C, et entraine la charge de celui-ci à travers la source de courant 16 fixée par exemple à 100 microampères. La charge rapide du condensateur C entraine une augmentation de la tension à la borne F de la résistance R25. Dans ces conditions, moins de courant est extrait des émetteurs de l'étage différentiel T1, T2 de l'amplificateur G1, ce qui entraine une diminution du gain de cet amplificateur et le signal de sortie Vout du préamplificateur 10 tend à être ramené à une valeur crête de 100mV. Il est important que le condensateur C se charge rapidement pour avoir une diminution rapide du gain du préamplificateur 10, cette diminution rapide du gain intervenant notamment lorsque le locuteur prend la parole.

Dans l'exemple considéré ici, le gain du préamplificateur 10 varie entre 12 et 38 dB pour une impédance d'entrée de 10 Kohms. Pour une dynamique du signal de sortie Vout fixée à 100 mV crête, le compresseur 1 asservira le signal de sortie Vout à 100 mV crête pour des dynamiques du signal d'entrée Vin variant entre 1,25 mV et 25 mV crête. Pour des signaux d'entrée Vin inférieurs à 1,25 mV crête, le gain du préamplificateur 1 est constant et égal à 38 dB, alors que pour des signaux d'entrée Vin supérieurs à 25 mV crête, le gain du préamplificateur est constant et égal à 12 dB.

D'une manière avantageuse, les circuits constituant le convertisseur de signal sont réalisés en technologie bipolaire, ce qui permet d'avoir une tension d'alimentation de 2,5 V compatible avec la téléphonie.

Bien entendu, l'invention n'est pas limitée au mode de réalisation décrit précédemment et comprend toutes les variantes de réalisation apparaissant à l'homme de l'art. En outre, le compresseur de signal conforme à l'invention peut être utilisé dans d'autres domaines que celui de la téléphonie.

## Revendications

1. Circuit compresseur de signal, en particulier pour appareil téléphonique du type "mains libres", comprenant un préamplificateur dont l'entrée est reliée à un signal d'entrée à traiter, et un dispositif de contrôle de gain du préamplificateur pour asservir, à une valeur prédéterminée, l'amplitude du signal de sortie du préamplificateur, dans lequel le dispositif de contrôle de gain (11) est associé à un circuit (C, 15, 16) définissant deux constantes de temps, qui commandent respectivement la vitesse d'augmentation et la vitesse de diminution du gain du préamplificateur (10) en fonction de l'amplitude du signal d'entrée (Vin), caractérisé en ce que le dispositif de contrôle de gain (11) comprend un circuit redresseur (12) pour extraire la valeur crête instantanée du signal de sortie (Vout) du préamplificateur (10), un circuit comparateur (13) pour comparer cette valeur crête à une valeur de référence (Vref), qui constitue la valeur prédéterminée précitée, et qui, suivant le résultat de cette comparaison commute l'une des sources de courant (15, 16) aux bornes du condensateur (C).

2. Circuit compresseur selon la revendication 1, caractérisé en ce que ledit circuit (C, 15, 16) comprend un condensateur (C), dont les temps de charge et de décharge fixent les constantes de temps précitées.

3. Circuit compresseur selon la revendication 2, caractérisé en ce que le condensateur (C) est associé à deux sources de courant (15, 16) qui assurent la décharge et la charge du condensateur (C), respectivement.

4. Circuit compresseur selon l'une quelconque des revendications 1 à 3, caractérisé en ce qu'il comprend un circuit de conversion tension-courant (18) pour convertir la tension variable aux bornes du condensateur (C) en un courant variable (13) de polarisation du préamplificateur (10) pour faire varier le gain de ce dernier.

5. Circuit compresseur selon la revendication 1, caractérisé en ce que le circuit redresseur (12) fournit en sortie un signal de courant, et en ce que la valeur de référence (Vref) est également transformée en un signal de courant par un circuit convertisseur (37).

6. Circuit compresseur selon l'une quelconque des revendications 1 à 5, caractérisé en ce que les constantes de temps de décharge et de charge du condensateur (C) sont dans un rapport notablement supérieur à l'unité.

7. Circuit compresseur selon la revendication 6, caractérisé en ce que ce rapport est de l'ordre de 100.

8. Circuit compresseur selon l'une quelconque des revendications 1 à 7, caractérisé en ce que le préamplificateur comprend :
   - un premier amplificateur (G1) recevant le signal d'entrée (Vin),
   - un deuxième amplificateur (G2) recevant le signal de sortie (Vout),

- un troisième amplificateur (G3) recevant les signaux de sortie des premier et deuxième amplificateurs,

et en ce que le premier amplificateur est connecté à une source de polarisation variable commandée par la sortie du circuit de contrôle de gain (11).

9. Appareil téléphonique, en particulier du type "mains libres", caractérisé en ce que les voies émission et réception sont chacune équipées d'un compresseur de signal tel que défini par l'une quelconque des revendications 1 à 8.

## Claims

1. A signal compression circuit, particularly for a telephone set of the handsfree-type, comprising a preamplifier, the input of which is connected with an input signal to be processed, and a preamplifier gain control device for servo-controlling, to a predetermined value, the amplitude of the preamplifier output signal, wherein the gain control device (11) is associated with a circuit (C, 15, 16) determining two time constants, which respectively control the increase speed and the decrease speed of the preamplifier gain (10) in relation with the input signal amplitude (Vin), characterized in that said gain control device (11) comprises a rectifying circuit (12) for extracting the instantaneous peak value of the output signal (Vout) of said preamplifier (10), a comparator circuit (13) for comparing this peak value with a reference value (Vref), which is said predetermined value, and which, according to the result of this comparison, switches one of the current sources (15, 16) across said capacitor (C).

2. A compression circuit according to claim 1, characterized in that said circuit (C, 15, 16) comprises a capacitor (C), the charge and discharge times of which determine said time constants.

3. A compression circuit according to claim 2, characterized in that said capacitor (C) is associated with two current sources (15, 16) which respectively ensure the discharge and charge of said capacitor (C).

4. A compression circuit according to any of claims 1 to 3, characterized in that it comprises a voltage-current converting circuit (18) for transforming the variable voltage at the terminals of said capacitor (C) into a variable biasing current (13) of the preamplifier (10) to permit the gain thereof to vary.

5. A compression circuit according to claim 1, characterized in that the rectifying circuit (12) provides an output curent signal, and wherein the reference value (Vref) is also transformed into a current signal by a converter circuit (37).

6. A compression circuit according to any of claims 1 to 5, characterized in that the discharge and charge time constants of said capacitor (C) have a ratio substantially higher than the unit.

7. A compression circuit according to claim 6, characterized in that said ratio is substantially equal to 100.

8. A compression circuit according to any of claims 1 to 7, characterized in that the preamplifier comprises :
   - a first amplifier (G1) receiving the input signal (Vin);
   - a second amplifier (G2) receiving the output signal (Vout);
   - a third amplifier (G3) receiving the output signals from the first and second amplifiers;

   and the first amplifier is connected with a variable biasing source controlled by the output of the gain control circuit (11).

9. A telephone set, more particularly of the handsfree-type, wherein each emission and reception channel is fitted with a signal compressor as claimed in any of claims 1 to 8.

## Patentansprüche

1. Signalkompressorschaltung, insbesondere für Fernsprechapparate des Freisprechtyps, mit einem Vorverstärker, dessen Eingang mit einem zu behandelnden Eingangssignal verbunden ist, und mit einer Regeleinrichtung für den Verstärkungsgrad des Vorverstärkers, um die Amplitude des Ausgangssignals des Vorverstärkers geregelt auf einem vorbestimmten Wert zu halten, wobei die Regeleinrichtung (11) für den Verstärkungsgrad mit einer Schaltung (C, 15, 16) gekoppelt ist, die zwei Zeitkonstanten definiert, welche die Geschwindigkeit zum Erhöhen bzw. Erniedrigen des Verstärkungsgrades des Vorverstärkers (10) als Funktion der Amplitude des Eingangssignals (Vin) bestimmen, dadurch gekennzeichnet, daß die Regeleinrichtung (11) für den Verstärkungsgrad eine Gleichrichterschaltung (13) zum Erfassen des momentanen Spitzenwertes des Ausgangssignals (Vout) des Vorverstärkers (10) und eine Vergleichsschaltung (13) zum Vergleichen des Spitzenwertes mit einem dem obigen vorbestimmten Wert entsprechenden Referenzwert (Vref) aufweist, die entsprechend des Vergleichsergebnisses eine der Stromquellen (15, 16) an die Anschlüsse des Kondensators (C) schaltet.

2. Signalkompressorschaltung nach Anspruch 1, dadurch gekennzeichnet, daß die Schaltung (C, 15, 16) einen Kondensator (C) enthält, dessen Lade- bzw. Endladezeiten die vorerwähnten Zeitkonstanten festlegen.

3. Signalkompressorschaltung nach Anspruch 2, dadurch gekennzeichnet, daß der Kondensator (C) mit zwei Stromquellen (15, 16) verbunden ist, die das Entladen bzw. das Laden des Kondensators (C) sicherstellen.

4. Signalkompressorschaltung nach einem der Ansprüche 1 bis 3, dadurch gekennzeichnet, daß sie eine Spannungs-Strom-Wandlerschaltung (18) aufweist zum Umwandeln der variablen Spannung an den Anschlüssen des Kondensators (C) in einen variablen Vorsteuerstrom (13) des Vorverstärkers (10), um dessen Verstärkungsgrad zu variieren.

5. Signalkompressorschaltung nach Anspruch 1, dadurch gekennzeichnet, daß die Gleichrichterschaltung (12) an ihrem Ausgang ein Stromsignal abgibt, und daß der Referenzwert (Vref) durch eine Wandlerschaltung (37) ebenfalls in ein Stromsignal transformiert wird.

6. Signalkompressorschaltung nach einem der Ansprüche 1 bis 5, dadurch gekennzeichnet, daß die Zeitkonstanten des Kondensators (C) zum Entladen und Laden zueinander ein Verhältnis größer als Eins aufweisen.

7. Signalkompressorschaltung nach Anspruch 6, dadurch gekennzeichnet, daß das Verhältnis in der Größenordnung von Hundert liegt.

8. Signalkompressorschaltung nach einem der Ansprüche 1 bis 7, dadurch gekennzeichnet, daß der Vorverstärker folgende Merkmale aufweist:
- einen ersten Verstärker (G1), der das Eingangssignal (Vin) empfängt,
- einen zweiten Verstärker (G2), der das Ausgangssignal (Vout) empfängt,
- einen dritten Verstärker (G3), der die Ausgangssignale des ersten und zweiten Verstärkers empfängt,
und daß der erste Verstärker mit einer variablen Vorsteuerquelle verbunden ist, die durch den Ausgang der Regeleinrichtung (11) für den Verstärkungsgrad gesteuert wird.

9. Telefonapparat, insbesondere vom Freisprechtyp, dadurch gekennzeichnet, daß die Sende- und Empfangskanäle jeweils mit einer Signalkompressorschaltung entsprechend einem der bisherigen Patentansprüche 1 bis 8 ausgerüstet sind.

**Figure 1**

**Figure 2**

Figure 3

Figure 4

EP 0 305 301 B1